# EUROPEAN PATENT SPECIFICATION

(11) **EP 1 658 640 B1**
(45) Date of publication and mention of the grant of the patent: **21.05.2014**
(21) Application number: 04736438.5
(22) Date of filing: 09.06.2004
(51) Int. Cl.: H01L 27/32, H01L 51/52

(54) **BARRIER LAMINATE FOR AN ELECTROLUMINESCENT DEVICE**
BARRIERESCHICHTEN FÜR ELEKTROLUMINESZIERENDE VORRICHTUNG
STRATIFIE FORMANT BARRIERE POUR DISPOSITIF ELECTROLUMINESCENT

(30) Priority: 16.06.2003 EP 03101759
(43) Date of publication of application: 24.05.2006
(73) Proprietor: Koninklijke Philips N.V., 5656 AE Eindhoven (NL)
(72) Inventor: MUTSAERS, Cornelis, A., H., A., NL-5656 AA Eindhoven (NL); SLIKKERVEER, Peter, J., NL-5656 AA Eindhoven (NL)
(74) Representative: Tol, Arie Jan Willem
(86) International application number: PCT/IB2004/050873
(87) International publication number: WO 2004/112165

(56) References cited:
- WO-A-02/071506
- US-B1- 6 268 695

## Description

### FIELD OF THE INVENTION

The present invention relates to a barrier laminate and an electroluminescent device comprising such laminate. The laminate comprises planarisation and barrier materials. The invention also relates to methods for the manufacture of a barrier laminate, as well as to the use of such a barrier laminate.

### BACKGROUND OF THE INVENTION

In the manufacture of displays, in particular flexible displays, most of the substrates are built up by polymer layers and layers of barrier material.

A flexible display can be manufactured e.g. in a flat panel display process like an Organic Light Emitting Display process, using a flexible substrate and a flexible cover. Both the cover and the substrate must contain one or more barrier layers impermeable to oxygen and water in order to protect the cell content from physical and/or chemical degradation. Oxidation is the case for Organic electroluminescent devices and polymer electroluminescent devices in particular are sensitive to oxidation. For other displays it might be a physical degradation, like leakage current by water presence. Preferably, a number of barrier layers is used in order to hamper the diffusion of water and oxygen as much as possible.

Polymer electroluminescent devices need very high quality barrier layers. At the moment the best option for high barrier layers is a very high quality multi-layer stack. The multi-layer stack consists of alternatively barrier layers and planarisation layers. The multi-layer is needed since there is no process that can deposit defect free inorganic layers on large surfaces. Current organic/inorganic barrier systems are, however, fundamentally flawed.

The multi-layer barrier consists of alternating barrier layers and planarisation layers. The deposition process for these layers is, however, not perfect and gives pinholes. The planarisation layers in the stack need to smoothen the surface to prevent that the pinholes in the previous layer are continued in the next layer.

One example of a current barrier system is a multi-layered structure, containing a number of thin inorganic and organic layers. Each inorganic layer is non-hermetic. The organic layers smoothens the surface, and basically decouple the defects in the inorganic layers.

The diffusion of water and/or oxygen will take place through the pinholes in the barrier layers. Each layer will contain some pinholes so the diffusion will take place in a meander like way. An example of such a foil is Vitex Flexible Glass (barix™).

By adding more layers in the barrier stack, the decoupling of the defects provides a seal which in principle leaks, but with a very long diffusion path (known as a so-called "labyrint seal"). A number of five inorganic layers is required to give reasonable barrier properties.

The system works for infinite plates, but stops work near edges of the substrate. These edges occur naturally when the individual displays are separated from a larger processed foil. The barrier properties of the side faces of a barrier laminate are significantly worse than the barrier properties provided by the major surfaces.

In a production process of flexible displays a number of devices will be built up on one single foil which will be separated afterwards. The organic (smoothening) layers are then exposed to the environment at the side of the substrate and a diffusion "short cut" arises. At the edges of the ultimate devices, where the foils have been cut, the diffusion of water and oxygen can take place directly through the top layer of the polymer into the device. The diffusion path is now reduced to the distance between the edge of the display area and diffusion bypasses all inorganic layers but the last one. Only the top layer has to be passed to reach the active device. Consequently, the pinhole density of the top barrier layer will determine the permeation resistance of these foils.

The quality is thus reduced to that of the last single inorganic layer, the rest of the layers become non-functional. Since five inorganic layers are needed to have reasonable properties, after separation this barrier will not function as a high barrier anymore.

In US 6 268 695, an environmental barrier for organic light emitting devices is disclosed. The function of the barrier is to prevent environmental constituents, e.g. water and oxygen, from reaching the OLED. The barrier constitutes a multi-layered structure, comprising at least three layers of polymers and ceramics, interchangeably. The barrier may be used as a foundation on a substrate as well as a cover placed over the OLED. The barrier can be made flexible.
WO 02/071506 discloses a multilayer encapsulation assembly for OLEDs arranged on a substrate. In one embodiment, the multilayer assembly comprises a polymer layer as the first encapsulation layer formed over the OLEDs and an oxide layer as a second encapsulation layer formed over the first encapsulation layer. At least a portion of the second encapsulation layer contacts the substrate.

However, nothing is mentioned in either of these documents regarding the problems with the impaired barrier properties of the side faces of barrier laminates when cut into smaller pieces.

### SUMMARY OF THE INVENTION

An object with the present invention is to provide a barrier laminate for electroluminescent devices, which laminate is impermeable to oxygen and/or water, and which may be cut into pieces without impairing the impermeability properties at the edges.

This object is achieved by including at least one discontinuous layer of a planarisation material in the barrier laminate, which layer is divided into unconnected areas distributed along the plane. Said unconnected areas are separated by regions of a barrier material.

Thereby, lateral gas and/or water barriers are included inside a planarisation layer in the laminate, in order to block diffusion paths through pin holes or at edges. The introduction of transverse barriers also increases the barrier properties in the normal direction, especially when there are less than one pinhole per chamber.

Planarisation materials to be used in the present invention are selected from the group consisting of parylene, acrylates, epoxides, urethanes, spin-on dielectrics, and siloxanes. Mostly, organic materials or combinations of organic and inorganic materials are used as planarisation materials.

The barrier layers suitably have an intrinsic permeability which is as low as possible. The barrier layers are made of inorganic materials selected from the group consisting of SiC, Si₃N₄, TiO₂ HfO₂, Y₂O₃, Ta₂O₅, Al₂O₃, but could also be made of combinations of organic and inorganic materials.

For example, the regions of barrier material forms a checked pattern, which renders it possible to sharply delimit the areas of planarisation material from each other.

Further, the barrier laminate may comprise at least one continuous layer of a planarisation material and at least two continuous layers of a barrier material. For example, the laminate contains five layers of planarisation material and six layers of barrier material. Thereby, the diffusion path through pinholes in the laminate is prolonged, and the barrier properties are improved. The number of layers may be fewer or more than the number mentioned above. The number of layers depends on the quality of the barrier layers in the laminate; the more pinholes, the more layers are required. The discontinuous layer is arranged between two continuous layers of a barrier material. Then, the barriers will meet and form a lateral barrier.

The discontinuous layer in a barrier laminate may be manufactured by depositing a continuous layer of a planarisation material, removing regions of said layer of a planarisation material, and filling said regions with a barrier material. Alternative techniques for removing regions of the planarisation material include lithographic techniques, eg expose and develop/etch, or laser ablation.

The discontinuous layer in a barrier laminate may also be manufactured by depositing a patterned layer of a planarisation material, whereby regions where no planarisation material is deposited is formed, and filling said regions with a barrier material. Alternative techniques for patterned deposition of the planarisation layer include printing techniques, like screen printing, inkjet printing, spraying, or patterned vacuum deposition, like evaporation through a shadow mask.

Suitably, the filling of the regions with a barrier material is performed in the same process step (simultaneously) as the deposition of a continuous barrier layer on top of the discontinuous layer. Thereby, the production process is rendered more effective.

One advantage of making planarisation layers from a liquid phase is that it forms "droplets shapes" with slanted edges, which makes a smooth deposition of the next barrier layer possible (better then when it had straight edges).

The present invention also relates to the use of a barrier laminate as an oxygen and/or water impermeable film.

The invention also relates to an electronic device, in particular an electroluminescent device, having active layers and a barrier laminate in accordance with the invention positioned over the active layers, the laminate having a discontinuous layer (4)which is, among the layers of the laminate containing planarisation material, the one closest to the active layers of said electroluminescent device.

Suitably, there is a barrier layer closest to the device, to prevent lateral diffusion through the top layer. The top layer could also be made of a planarisation material, but then interrupted at the edge seal of the electroluminescent device.

The discontinuous layer is preferably that layer of the layers containing planarisation material, which is arranged closest to the active layers of said electroluminescent device.

These and other aspects of the invention will be apparent from and elucidated with reference to the embodiment described hereafter.

### BRIEF DESCRIPTION OF THE DRAWING

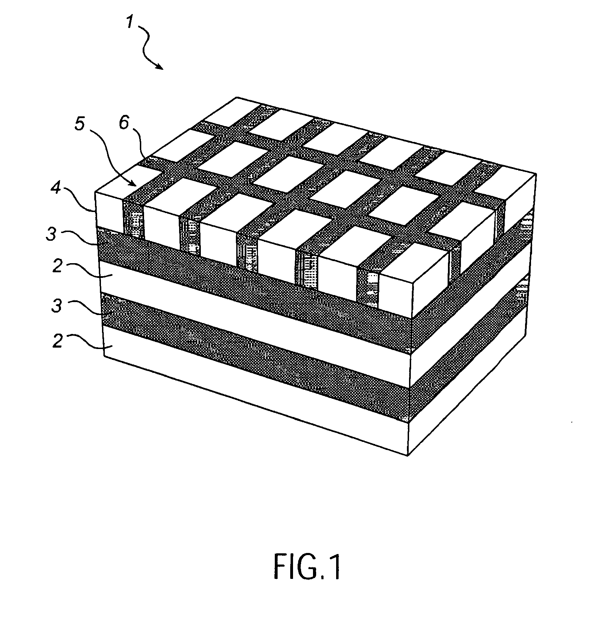

Fig. 1 shows an intersectional view of the barrier laminate according to the invention.

### DESCRIPTION OF PREFERRED EMBODIMENTS

In the research work leading to the present invention, it was found that by including lateral gas barriers inside a planarisation layer in a barrier laminate, the barrier properties for indiffusion via side faces is improved. The lateral barriers are included by making a discontinuous planarisation layer, forming separate islets (unconnected areas) of planarisation material, and incorporating barrier material between the planarisation material islets.

In fig. 1, one embodiment of the barrier laminate (1) according to the invention is illustrated. The barrier laminate (1) comprises continuous planarisation layers (2) and continuous barrier layers (3). In a stack of layers the discontinuous layer (4) is arranged as close as possible to the active layers of the electrolumine-scent device (not shown). It comprises areas (5) of plan-arisation material and regions (6) of barrier material.

The regions of barrier material forms lateral barriers, which can be positioned in all planarisation layers, but are optimal in the planarisataion layer closest to the device. The lateral barriers extend along the side face(s) and connect the layers directly adjacent to the planarisation layer.

The layers directly adjacent to the discontinuous planarisation layer are made of barrier material. The layers of barrier material will contain pinholes, and more than one layer of barrier material is usually needed to cover those holes. Inbetween the layers of barrier material, a planarisation layer is arranged to prevent diffusion through pinholes in the first layer to pinholes in the second barrier layer. The transverse barriers in the planarisation layer work best if they have a barrier on top and on the bottom. Thereby, the barriers will meet and form the wanted lateral barrier.

Thus, barrier layers are applied not only in a horizontal, but also in a vertical direction at appropriate distances. The vertical barriers efficiently prevent oxygen and/or moisture to diffuse into the planarisation layer, whereby the risk of diffusion into another layer in the laminate is minimised. The transverse barriers in subsequent layers could be aligned (preferably) or not (e.g. random, easier to process).

For this to work well, the regions of barrier material should form a kind of grid. In a top view, the barrier pattern may look for instance like squares or like bricks in a wall (hexagonals in closed package). The density of the pattern can be adjusted to the application. The number of barrier layers per centimetre will determine the resistance for the diffusion of the water etc in a horizontal direction through the laminate.

When making a laminate with more than one discontinuous planarisation layers, there is an advantage to have the lateral barriers staggered (not on top of each other): when a pinhole is present in the area of the lateral barrier, the continuation in the next layer is prevented.

It is also possible to make a barrier laminate comprising discontinuous layers only.

The planarisation material used according to the present invention is suitably a polymeric material. Examples of planarisation materials to be used in the present invention are parylene, acrylates, epoxides, urethanes, spin-on dielectrics, and siloxanes.

Examples of barrier materials to be used in the present invention are SiO₂, SiC, Si₃N₄, TiO₂ HfO₂, Y₂O₃, Ta₂O₅, Al₂O₃.

It is possible to mix different types of organic and inorganic materials in one barrier laminate. Then, the different layers in the stack may be optimised to give the optimal result. However, from a processing point of view, limiting the number of materials might be advantageous.

The lateral barriers, i.e. the regions of barrier material, can be made by patterned deposition of the planarisation layer. Where the planarisation material is not deposited, the barrier material will be deposited.

Another way to manufacture the discontinuous layer is to evaporate a deposited monomer (oligomer) trough a shadow mask and than filling the spaces with a barrier material. Filling of the spaces with barrier material may be done simultaneously with deposition of the next barrier layer.

The discontinuous layer can also be manufactured by etching a pattern in the planarisation layer and filling the spaces with the barrier material.

Examples of manufacturing methods are, either deposition from a gas phase, or from a liquid (printing, e.g. ink-jet, flexo, gravure or coating and litho patterning), or transfer from solid (e.g. thermotransfer, Screen printing).

The barrier laminate according to the invention may be used as an oxygen and/or water barrier on a substrate for electroluminescent devices. The laminate is especially suited for flexible substrates.

The barrier laminate according to the invention may also be used in covers for electroluminescent devices, including hermetic coatings on top of a device, not being part of a substrate. The laminate is especially suited for flexible covers.

The barrier laminate according to the invention may be used as barrier film on a non-hermetic substrate, e.g. a polymeric film like PC, PES, PAR, PNB, PET, PEN, etc. It may also be used as a coating on top of the device, e.g. the stack would include base substrate, barrier laminate, device, barrier laminate, where the bottom barrier laminate on the substrate can be omitted when the substrate is hermetic itself.

As used herein, the expression "barrier laminate" relates to a multi-layered structure comprising planarisation and barrier materials. Generally, the laminate comprises planarisation and barrier layers, interchangeably.

As used herein, the expression "electroluminescent device" includes light emitting diode (LED) based devices, such as organic LEDs and polymer LEDs in particular, including both displays and lighting devices. The devices may be of active or passive type.

The barrier laminate according to the invention is especially suited for use in very thin, lightweight and even flexible/roll-up displays. The barrier laminate according to the invention is also suited for use in lighting devices (lamps).

As used herein, the expression "discontinuous layer" relates to a layer which is divided into unconnected areas. Preferably, the unconnected areas consist of planarisation material, and these areas are separated by regions of barrier material.

If the transverse barriers are non continuous (not completely surrounding islands of planarisation material) they still add to the barrier properties, since they lengthen the diffusion path as a normal labyrinth seal does (like the distance you walk in and into a labyrinth).

As used herein, the expression "continuous layer" relates to a layer which is distributed along the entire plane, without disruptions.

As used herein, the expression "checked pattern" relates to a pattern which divides a plane into separate areas, which are uncontactable. For example, the checked pattern forms a grid-like structure.

As used herein, the expression "active layers" of an electroluminescent device refers to e.g. the cathode, the anode and the electroluminescent material of such a device.

As used herein, the expression "oxygen and/or water impermeable film" relates to a material which is a barrier to oxygen and/or water, i.e. a material which does not allow oxygen and/or water to pass through it.

The present invention thus provides a new barrier laminate for use as impermeable layer for oxygen and/or water in electroluminescent devices. The laminate has excellent barrier properties along its entire surface. It can be manufactured as a single foil, which later can be cut into smaller pieces, without risking poor barrier properties at the edges.

## Claims

1. A barrier laminate (1) for an electroluminescent device, comprising a material selected from the group consisting of SiO₂, SiC, Si₃N₄, TiO₂ HfO₂, Y₂O₃, Ta₂O₅, and Al₂O₃ as a barrier material, and a material selected from the group consisting of parylene, acrylates, epoxides, urethanes, spin-on dielectrics, and siloxanes as a planarisation material, said barrier laminate (1) containing at least one discontinuous layer (4) of said planarisation material, which layer is divided into unconnected areas (5) distributed along the plane, wherein said unconnected areas (5) are separated by regions (6) of said barrier material, **characterized in that** said discontinuous layer (4) is arranged between two continuous layers (3) of said barrier material.

2. A barrier laminate (1) according to claim 1, wherein said planarisation material is an organic material.

3. A barrier laminate (1) according to claim 1, wherein said planarisation material is a combination of organic and inorganic materials.

4. A barrier laminate (1) according to any one of the claims 2-3, wherein said regions (6) of a barrier material forms a checked pattern.

5. A barrier laminate (1) according to any one of the preceding claims, further comprising at least one continuous layer (2) of a planarisation material.

6. A barrier laminate (1) according to any one of the previous claims, wherein said planarisation material is a polymeric material.

7. Use of a barrier laminate (1) according to any one of the preceding claims as an oxygen and/or water impermeable film.

8. A method for the manufacture of a discontinuous layer (4) in a barrier laminate (1) according to any one of the claims 1 to 6, comprising:
- depositing a continuous layer of a planarisation material selected from the group consisting of parylene, acrylates, epoxides, urethanes, spin-on dielectrics, and siloxanes,
- removing regions of said layer of a planarisation material, and
- filling said regions with a barrier material selected from the group consisting of SiO₂, SiC, Si₃N₄, TiO₂ HfO₂, Y₂O₃, Ta₂O₅, and Al₂O₃.

9. A method for the manufacture of a discontinuous layer (4) in a barrier laminate (1) according to any one of the claims 1 to 6, comprising:
- depositing a patterned layer of a planarisation material selected from the group consisting of parylene, acrylates, epoxides, urethanes, spin-on dielectrics, and siloxanes, whereby regions where no planarisation material is deposited are formed, and
- filling said regions with a barrier material selected from the group consisting of SiO₂, SiC, Si₃N₄, TiO₂ HfO₂, Y₂O₃, Ta₂O₅, and Al₂O₃.

10. A method according to claim 8 or 9, wherein said filling of said regions with a barrier material is performed simultaneously as the deposition of a continuous layer of a barrier material on said discontinuous layer.

11. An electroluminescent device having active layers and a barrier laminate (1) according to any one of the claims 1 to 6 positioned over the active layers, the laminate having a discontinuous layer (4) which is, among the layers of the laminate containing planarisation material, the one closest to the active layers of said electroluminescent device.

12. An electroluminescent device according to claim 11 which is an organic LED based device.

13. An electroluminescent device according to claim 11 which is a lighting device.

14. An electroluminescent device according to claim 11 which is a flexible display.

15. Use of a barrier laminate according to any one of the claims 1 to 6 in a flexible cover for an electroluminescent device.

## Patentansprüche

1. Barrierelaminat (1) für eine Elektrolumineszenzeinrichtung, umfassend ein Material, das aus der Gruppe, bestehend aus SiO₂, SiC, Si₃N₄, TiO₂, HfO₂, Y₂O₃, Ta₂O₅ und Al₂O₃ als Barrierematerial ausgewählt wird, sowie ein Material, das aus der Gruppe, bestehend aus Parylen, Acrylaten, Epoxiden, Urethanen, Spin-on-Dielektrika sowie Siloxanen als Planarisierungsmaterial, ausgewählt wird, wobei das Barrierelaminat (1) mindestens eine diskontinuierliche Schicht (4) aus dem Planarisierungsmaterial enthält, wobei die Schicht in entlang der Ebene verteilte, unverbundene Flächen (5) unterteilt ist, wobei die unverbundenen Flächen (5) durch Bereiche (6) aus dem Barrierematerial getrennt sind, **dadurch gekennzeichnet, dass** die diskontinuierliche Schicht (4) zwischen zwei kontinuierlichen Schichten (3) aus dem Barrierematerial angeordnet isst.

2. Barrierelaminat (1) nach Anspruch 1, wobei das Planarisierungsmaterial ein organisches Material ist.

3. Barrierelaminat (1) nach Anspruch 1, wobei das Planarisierungsmaterial eine Kombination aus organischen und anorganischen Materialien ist.

4. Barrierelaminat (1) nach einem der Ansprüche 2-3, wobei die Bereiche (6) aus einem Barrierematerial ein Karomuster bilden.

5. Barrierelaminat (1) nach einem der vorangegangenen Ansprüche, das weiterhin mindestens eine kontinuierliche Schicht (2) aus einem Planarisierungsmaterial umfasst.

6. Barrierelaminat (1) nach einem der vorangegangenen Ansprüche, wobei das Planarisierungsmaterial ein polymeres Material ist.

7. Verwendung eines Barrierelaminats (1) nach einem der vorangegangenen Ansprüche als ein sauerstoff- und/oder wasserundurchlässiger Film.

8. Verfahren zur Herstellung einer diskontinuierlichen Schicht (4) in einem Barrierelaminat (1) nach einem der Ansprüche 1 bis 6, wonach:
- eine kontinuierliche Schicht aus einem Planarisierungsmaterial, das aus der Gruppe, bestehend aus Parylen, Acrylaten, Epoxiden, Urethanen, Spin-on-Dielektrika sowie Siloxanen, ausgewählt wird, aufgebracht wird,
- Bereiche der Schicht aus einem Planarisierungsmaterial entfernt werden, und
- die Bereiche mit einem Barrierematerial, das aus der Gruppe, bestehend aus SiO₂, SiC, Si₃N₄, TiO₂, HfO₂, Y₂O₃, Ta₂O₅ und Al₂O₃, ausgewählt wird, ausgefüllt werden.

9. Verfahren zur Herstellung einer diskontinuierlichen Schicht (4) in einem Barrierelaminat (1) nach einem der Ansprüche 1 bis 6, wonach:
- eine strukturierte Schicht aus einem Planarisierungsmaterial, das aus der Gruppe, bestehend aus Parylen, Acrylaten, Epoxiden, Urethanen, Spin-on-Dielektrika sowie Siloxanen, ausgewählt wird, aufgebracht wird, wodurch Bereiche, in denen kein Planarisierungsmaterial deponiert wird, gebildet werden, und
- die Bereiche mit einem Barrierematerial, das aus der Gruppe, bestehend aus SiO₂, SiC, Si₃N₄, TiO₂, HfO₂, Y₂O₃, Ta₂O₅ und Al₂O₃, ausgewählt wird, ausgefüllt werden.

10. Verfahren nach Anspruch 8 oder 9, wobei das Ausfüllen der Bereiche mit einem Barrierematerial zur gleichen Zeit wie das Aufbringen einer kontinuierlichen Schicht aus einem Barrierematerial auf der diskontinuierlichen Schicht durchgeführt wird.

11. Elektrolumineszenzeinrichtung mit aktiven Schichten und einem über den aktiven Schichten positionierten Barrierelaminat (1) nach einem der Ansprüche 1 bis 6, wobei das Laminat eine diskontinuierliche Schicht (4) aufweist, die unter den Planarisierungsmaterial enthaltenden Schichten des Laminats die am nächsten an den aktiven Schichten der Elektrolumineszenzeinrichtung liegende Schicht ist.

12. Elektrolumineszenzeinrichtung nach Anspruch 11, bei der es sich um eine organische LED-basierte Einrichtung handelt.

13. Elektrolumineszenzeinrichtung nach Anspruch 11, bei der es sich um eine Beleuchtungseinrichtung handelt.

14. Elektrolumineszenzeinrichtung nach Anspruch 11, bei der es sich um ein flexibles Display handelt.

15. Verwendung eines Barrierelaminats nach einem der Ansprüche 1 bis 6 in einer flexiblen Abdeckung für eine Elektrolumineszenzeinrichtung.

## Revendications

1. Stratifié barrière (1) pour un dispositif électroluminescent, comprenant un matériau sélectionné parmi le groupe constitué de SiO₂, de SiC, de Si₃N₄, de TiO₂ HfO₂, de Y₂O₃, de Ta₂O₅, et de Al₂O₃ en tant que matériau barrière, et un matériau sélectionné parmi le groupe constitué de parylène, d'acrylates, d'époxydes, d'uréthanes, de diélectriques déposés par rotation, et de siloxanes en tant que matériau de planarisation, ledit stratifié barrière (1) contenant au moins une couche discontinue (4) dudit matériau de planarisation, laquelle couche est divisée en zones non raccordées (5) distribuées le long du plan, dans lequel lesdites zones non raccordées (5) sont séparées par des régions (6) dudit matériau barrière, **caractérisé en ce que** ladite couche discontinue (4) est agencée entre deux couches continues (3) dudit matériau barrière.

2. Stratifié barrière (1) selon la revendication 1, dans lequel ledit matériau de planarisation est un matériau organique.

3. Stratifié barrière (1) selon la revendication 1, dans lequel ledit matériau de planarisation est une association de matériaux organique et inorganique.

4. Stratifié barrière (1) selon une quelconque des revendications 2 et 3, dans lequel lesdites régions (6) d'un matériau barrière forment un motif quadrillé.

5. Stratifié barrière (1) selon une quelconque des revendications précédentes, comprenant en outre au moins une couche continue (2) d'un matériau de planarisation.

6. Stratifié barrière (1) selon une quelconque des revendications précédentes, dans lequel ledit matériau de planarisation est un matériau polymérique.

7. Utilisation d'un stratifié barrière (1) selon une quelconque des revendications précédentes en tant que film imperméable à l'oxygène et/ou à l'eau.

8. Procédé pour la fabrication d'une couche discontinue (4) dans un stratifié barrière (1) selon une quelconque des revendications 1 à 6, comprenant :
- le dépôt d'une couche continue d'un matériau de planarisation sélectionné parmi le groupe constitué de parylène, d'acrylates, d'époxydes, d'uréthanes, de diélectriques déposés par rotation, et de siloxanes,
- l'enlèvement de régions de ladite couche d'un matériau de planarisation, et
- le remplissage desdites régions avec un matériau barrière sélectionné parmi le groupe constitué de SiO₂, de SiC, de Si₃N₄, de TiO₂ HfO₂, de Y₂O₃, de Ta₂O₅, et de Al₂O₃.

9. Procédé pour la fabrication d'une couche discontinue (4) dans un stratifié barrière (1) selon une quelconque des revendications 1 à 6, comprenant :
- le dépôt d'une couche à motif d'un matériau de planarisation sélectionné parmi le groupe constitué de parylène, d'acrylates, d'époxydes, d'uréthanes, de diélectriques déposés par rotation, et de siloxanes, moyennant quoi des régions où aucun matériau de planarisation n'est déposé sont formées, et
- le remplissage desdites régions avec un matériau barrière sélectionné parmi le groupe constitué de SiO₂, de SiC, de Si₃N₄, de TiO₂ HfO₂, de Y₂O₃, de Ta₂O₅, et de Al₂O₃.

10. Procédé selon la revendication 8 ou 9, dans lequel ledit remplissage desdites régions avec un matériau barrière est réalisé simultanément au dépôt d'une couche continue d'un matériau barrière sur ladite couche discontinue.

11. Dispositif électroluminescent comportant des couches actives et un stratifié barrière (1) selon une quelconque des revendications 1 à 6 positionné sur les couches actives, le stratifié comportant une couche discontinue (4) qui est, parmi les couches du stratifié contenant un matériau de planarisation, celle la plus proche des couches actives dudit dispositif électroluminescent.

12. Dispositif électroluminescent selon la revendication 11, qui est un dispositif à base de LED organique.

13. Dispositif électroluminescent selon la revendication 11, qui est un dispositif d'éclairage.

14. Dispositif électroluminescent selon la revendication 11, qui est un affichage flexible.

15. Utilisation d'un stratifié barrière selon une quelconque des revendications 1 à 6 dans une couverture flexible pour un dispositif électroluminescent.
